# EUROPÄISCHE PATENTSCHRIFT

(11) **EP 1 495 151 B1**
(45) Veröffentlichungstag und Bekanntmachung des Hinweises auf die Patenterteilung: **26.11.2008**
(21) Anmeldenummer: 03706200.7
(22) Anmeldetag: 18.03.2003
(51) Int. Cl.: C23C 4/12

(54) **PLASMASPRITZVERFAHREN**
PLASMA INJECTION METHOD
PROCEDE DE PROJECTION AU PLASMA

(30) Priorität: 12.04.2002 EP 02405297
(43) Veröffentlichungstag der Anmeldung: 12.01.2005
(73) Patentinhaber: Sulzer Metco AG, 5610 Wohlen (CH)
(72) Erfinder: BARBEZAT, Gérard, CH-8152 Opfikon (CH); REFKE, Arno, CH-5507 Mellingen (CH); LOCH, Michael, 79664 Wehr (DE)
(74) Vertreter: Sulzer Management AG
(86) Internationale Anmeldenummer: PCT/CH2003/000175
(87) Internationale Veröffentlichungsnummer: WO 2003/087422

(56) Entgegenhaltungen:
- EP-A- 1 154 033
- WO-A-96/06200
- DE-A- 3 914 722
- DE-A- 4 114 962
- US-A- 5 201 939
- US-A- 5 332 601
- US-A- 5 830 586
- HILSCHER G: "KRUPP LANCIERT VAKUUMPLASMASPRITZEN FUR DEN MASCHINENBAU" TECHNISCHE RUNDSCHAU, HALLWAG VERLAG. BERN, CH, Bd. 82, Nr. 46, 16. November 1990 (1990-11-16), Seiten 60-61, XP000109903 ISSN: 1023-0823
- SEVOSTIANOV IGOR: "anisotropic thermal conductivities of plasma sprayed thermal barrier coatings" JOURNAL OF THERMAL SPAY TECHNOLOGY, Bd. 9, Nr. 4, 2000, Seiten 478-482, XP008008250
- YINGCHUN ZHU: "characterization of plasma sprayed nano-titania coatings" JOURNAL OF THE EUROPEAN CERAMIC SOCIETY, Bd. 20, - 2000 Seiten 127-132, XP002213888
- PATENT ABSTRACTS OF JAPAN vol. 009, no. 233 (C-304), 19. September 1985 (1985-09-19) & JP 60 092461 A (KOGYO GIJUTSUIN;OTHERS: 0J), 24. Mai 1985 (1985-05-24)
- PATENT ABSTRACTS OF JAPAN vol. 2000, no. 07, 29. September 2000 (2000-09-29) & JP 2000 119835 A (AGENCY OF IND SCIENCE &TECHNOL; LASER OYO KOGAKU KENKYUSHO:KK), 25. April 2000 (2000-04-25)
- SAMPATH S ET AL: "STRUCTURE AND PROPERTIES OF VACUUM PLASMA SPRAYED HARD COATINGS" MEMOIRES ET ETUDES SCIENTIFIQUES DE LA REVUE DE METALLURGIE, REVUE DE METALLURGIE. PARIS, FR, Bd. 88, Nr. 5, 1. Mai 1991 (1991-05-01), Seiten 289-294, XP000263470 ISSN: 0245-8292
- NEISER R.A. ET AL: 'EVALUATION OF PLASMA-SPRAYED TUNGSTEN FOR FUSION REACTORS' JOURNAL OF THERMAL SPRAY TECHNOLOGY Bd. 2, Nr. 4, 01 Dezember 1993, ASM INTERNATIONAL, MATERIALS PARK, US, Seiten 393 - 399, XP008056800

## Beschreibung

Die Erfindung betrifft ein Verfahren gemäss Oberbegriff von Anspruch 1. US-A-5 853 815 beschreibt ein thermisches Spritzen zur Herstellung eines sogenannten LPPS-Dünnfilms (LPPS = Low Pressure Plasma Spraying).

Mit dem LPPS-Dünnfilm-Prozess wird ein konventionelles LPPS-Plasmaspritzverfahren verfahrenstechnisch abgewandelt, wobei ein von Plasma durchströmter Raum ("Plasmaflamme" oder "Plasmastrahl") aufgrund der Änderungen ausgeweitet und auf eine Länge von bis zu 2.5 m ausgedehnt wird. Die geometrische Ausdehnung des Plasmas führt zu einer gleichmässigen Aufweitung - einer "Defokussierung" - eines Pulverstrahls, der mit einem Fördergas in das Plasma injiziert wird. Das Material des Pulverstrahls, das im Plasma zu einer Wolke dispergiert und dort teilweise oder vollständig geschmolzen wird, gelangt gleichmässig verteilt auf eine weit ausgedehnte Oberfläche eines Substrats. Es entsteht auf dem Substrat eine dünne Lage, deren Schichtdicke kleiner als 10 µm ist und die dank der gleichmässigen Verteilung eine dichte Abdeckung bildet. Durch mehrfachen Auftrag von dünnen Lagen kann eine dickere Beschichtung mit besonderen Eigenschaften hergestellt werden, was eine solche Beschichtung als Funktionsschicht verwendbar macht. Beispielsweise ist mit einem Mehrfachauftrag eine poröse Beschichtung herstellbar, die sich als Träger für katalytisch aktive Stoffe eignet (siehe EP-A- 1 034 843 = P.6947).

Eine Funktionsschicht, die auf einen das Substrat bildenden Grundkörper aufgebracht wird, umfasst in der Regel verschiedene Teilschichten. Beispielsweise werden für eine Gasturbine (stationäre Gasturbine oder Flugzeugtriebwerk), die bei hohen Prozesstemperaturen betrieben wird, die Schaufeln mit einer ersten ein- oder mehrlagigen Teilschicht beschichtet, die eine Beständigkeit gegen Heissgaskorrosion herstellt. Eine zweite Beschichtung, die auf die erste Teilschicht aufgebracht wird und für die keramisches Material verwendet wird, bildet eine Wärmedämmschicht. Das LPPS-Plasmaspritzverfahren eignet sich für die Herstellung der ersten Schicht. Die Wärmedämmschicht wird vorteilhafterweise mit einem Verfahren erzeugt, bei dem eine Beschichtung mit einer kolumnaren Mikrostruktur entsteht. Die so strukturierte Schicht setzt sich angenähert aus zylindrischen Körperchen oder Korpuskeln zusammen, deren Zentralachsen senkrecht zur Substratoberfläche ausgerichtet sind. Übergangsbereiche, in denen die Dichte des abgeschiedenen Materials kleiner als in den Korpuskeln ist, begrenzen die Korpuskeln seitlich. Eine Beschichtung, die solcherart eine anisotrope Mikrostruktur aufweist, ist dehnungstolerant gegenüber wechselnden Spannungen, die sich aufgrund von wiederholt auftretenden Temperaturänderungen ergeben. Die Beschichtung reagiert auf die wechselnden Spannungen auf eine weitgehend reversible Weise, d.h. ohne eine Ausbildung von Rissen, so dass ihre Lebensdauer beträchtlich verlängert ist im Vergleich mit der Lebensdauer einer üblichen Beschichtung, die keine kolumnare Mikrostruktur hat.

Dokument WO 96/06200 A offenbart ein Vakuumplasmaspritzverfahren, bei dem ein Beschichtungsmaterial in Form eines Pulverstrahls auf eine Oberfläche eines Substrats aufgespritzt wird, unter Verwendung von folgenden Prozessparameterbereiche : Druck: < 1.9984x 10 4 Pa ( 150 Torr; Leistung Plasmaspritzvorrichtung: > 40 kW; Prozessgas: Gemisch Argon (60-140 lit.min.) and Helium ( 3-40 lit.min.); Keramisches Pulver: <20 microm.; Pulverförderrate: 10 g./min.-30 g./min.

R.A. Neiser: " Evaluation of plasma-sprayed tungsten for fusion reactors", Journal of Thermal Spray Technology, Vol.2, No.4, 1993, Seiten 393-399; XP 008056800 beschreibt das LPPS-Spritzen von Wolfram mit anisotroper Strukturierung.

Dokument US-A-5201939 offenbart ein Plasmaspritzverfahren zur Herstellung einer Schicht, wobei ein Anteil des pulverförmigen Beschichtungsmaterials in die Dampfphase übergeht durch Regelung der Prozessparameter.

Dokument De 4114962 A offenbart ein Verfahren zur Herstellung von Multilayerschichten mittels Vakuumplasmaspritzen, wobei die einzelnen dünnen Lagen in einem Arbeitszyclus aufgebracht werden.

Dokument Chemical Abstracts, AN 120:223972, "The microstructure of functionally gradient material made by plasma spraying", Hamatami, Hideki ; Yosetsu Gakkai Ronbunshu ( 1993), 11 (4), 576-82 offenbart ein Verfahren zur Herstellung einer Schicht mit kolumnarer Struktur mittels Plasmaspritzen bei niedrigen Prozessdruck.

Die anisotrope Mikrostruktur ist mit einem Dünnfilmverfahren erzeugbar, das ein Aufdampfverfahren ist. Bei diesem Verfahren, das man mit "EB-PVD" (Electron Beam - Physical Vapor Deposition) bezeichnet, wird die für die Wärmedämmschicht abzuscheidende Substanz in einem Hochvakuum mit einem Elektronenstrahl in die Dampfphase gebracht und aus dieser auf den zu beschichtenden Bauteil auskondensiert. Werden die Prozessparameter geeignet gewählt, so ergibt sich eine kolumnare Mikrostruktur. Ein Nachteil dieses Aufdampfverfahrens sind hohe Anlagenkosten. Es kommt hinzu, dass bei der Herstellung einer mehrere Teilschichten umfassenden Beschichtung nicht die gleiche Anlage für das LPPS-Plasmaspritzverfahren und den EB-PVD-Prozess eingesetzt werden kann. Für die Beschichtung sind daher mehrere Arbeitszyklen durchzuführen.

Aufgabe der Erfindung ist es, ein Verfahren zu schaffen, mit dem eine Wärmedämmschicht herstellbar ist und das erlaubt, eine die Wärmedämmschicht als Teilschicht umfassende Beschichtung in einem Arbeitszyklus auf ein Substrat aufzubringen. Diese Aufgabe wird durch das im Anspruch 1 definierte Verfahren gelöst.

Das Plasmaspritzverfahren ist ein Beschichtungsverfahren, bei dem ein zu beschichtendes Material in Form eines Pulverstrahls auf eine Oberfläche eines metallischen Substrats aufgespritzt wird. Es wird bei einem niedrigen Prozessdruck, der kleiner als 10 000 Pa ist, das Beschichtungsmaterial in ein den Pulverstrahl defokussierendes Plasma injiziert und dort teilweise oder vollständig geschmolzen. Dabei wird ein Plasma mit ausreichend hoher spezifischer Enthalpie erzeugt, so dass ein substanzieller, mindestens 5 Gew-% betragender Anteil des Beschichtungsmaterials in die Dampfphase übergeht. Auf dem Substrat wird mit dem Beschichtungsmaterial eine anisotrop strukturierte Schicht aufgetragen. In dieser Schicht sind längliche Korpuskeln, die eine anisotrope Mikrostruktur bilden, weitgehend senkrecht zur Substratoberfläche stehend ausgerichtet. Materialarme Übergangsbereiche begrenzen die Korpuskeln gegeneinander.

Das erfndungsgemässe Verfahren weist gegenüber dem bekannten Verfahren, mit dem eine kolumnar strukturierte Schicht mittels EB-PVD hergestellt wird, einen weiteren Vorteil auf: Die Prozesszeiten für gleich dicke Schichten sind deutlich kürzer.

Die abhängigen Ansprüche 2 bis 12 betreffen vorteilhafte Ausführungsformen des erfindungsgemässen Verfahrens.

Nachfolgend wird die Erfindung im Zusammenhang mit Zeichnungen beschrieben. Es zeigen:
- Fig. 1: eine anisotrop strukturierte, nach dem erfindungsgemässen Verfahren hergestellte Schicht, gezeichnet nach einem Schliffbild,
- Fig. 2: eine entsprechende zweite Schicht, die nach einer ungünstigen Änderung eines Prozessparameters entstanden ist,
- Fig. 3: eine dritte Schicht, bei der nach einer weiteren Änderung des gleichen Prozessparameters keine anisotrope Mikrostruktur mehr erkennbar ist, und
- Fig. 4: eine schematische Darstellung eines Schichtsystems mit einer Wärmedämmschicht.

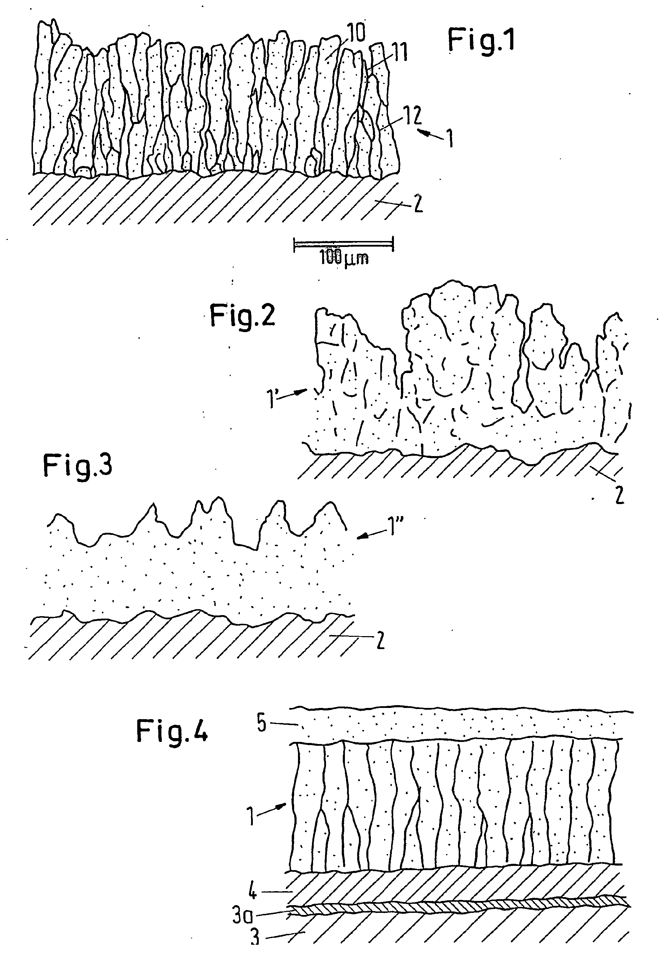

In Fig. 1 ist ein Schnitt durch eine nach dem erfindungsgemässen Verfahren hergestellte Schicht 1 dargestellt, die nach einem Schliffbild gezeichnet ist. Die mit dem LPPS-Dünnfilm-Prozess auf ein Substrat 2 abgelagerte Schicht 1 ist anisotrop strukturiert und hat eine Schichtdicke von rund 150 µm. Die anisotrope Mikrostruktur wird durch längliche Korpuskeln 10 gebildet, die weitgehend senkrecht zur Substratoberfläche stehen. Materialarme Übergangsbereiche 12, die als Linien gezeichnet sind, und spaltförmige Zwischenräume 11 begrenzen die Korpuskeln 10 gegeneinander. Als Beschichtungsmaterial ist Zirkoniumoxid, das mit Yttrium Y stabilisiert ist, verwendet worden, nämlich ZrO₂-8%Y₂O₃. Das Substrat 2 ist in der Regel eine Haftvermittlungsschicht oder eine Schutzschicht gegen Korrosion.

Damit die anisotrope Mikrostruktur entsteht, muss ein Plasma mit ausreichend hoher spezifischer Enthalpie erzeugt werden, so dass ein substanzieller, mindestens 5 Gew-% betragender Anteil des Beschichtungsmaterials in die Dampfphase übergeht. Der Anteil des verdampften Materials, das nicht vollständig in die Dampfphase übergehen darf, kann bis zu 70 % betragen. Das Plasma wird in einem Brenner mit einem elektrischen Gleichstrom und mittels einer Stiftkatode sowie einer ringförmigen Anode erzeugt. Die dem Plasma zugeführte Leistung, die effektive Leistung, muss empirisch bezüglich der resultierenden Schichtstruktur ermittelt werden. Die effektive Leistung, die durch die Differenz zwischen der elektrischen Leistung und der durch Kühlung abgeführten Wärme gegeben ist, liegt erfahrungsgemäss im Bereich von 40 bis 80 kW.

Für den Prozessdruck des erfindungsgemässen Plasmaspritzverfahrens wird ein Wert zwischen 50 und 2000 Pa gewählt, vorzugsweise zwischen 100 und 800 Pa. Ein Pulverstrahl wird mit einem Fördergas in das Plasma injiziert. Das Prozessgas für die Erzeugung des Plasmas ist ein Gemisch von Inertgasen, insbesondere eine Gemisch von Argon Ar und Helium He, wobei das Volumenverhältnis von Ar zu He vorteilhafterweise im Bereich von 2 : 1 bis 1 : 4 liegt. Der Gesamtgasfluss liegt im Bereich von 30 bis 150 SLPM (Standard Liter Per Minute). Die Pulverförderrate liegt zwischen 5 und 60 g/min, vorzugsweise zwischen 10 und 40 g/min. Der Pulverstrahl wird im defokussierenden Plasma zu einer Wolke aus Dampf und Partikeln umgeformt. Vorzugsweise wird das Substrat während des Materialauftrags mit Dreh- oder Schwenkbewegungen relativ zu dieser Wolke bewegt. Dabei wird die Wärmedämmschicht durch Abscheiden einer Mehrzahl von Lagen aufgebaut. Die gesamte Schichtdicke weist Werte zwischen 20 und 1000 µm, vorzugsweise Werte von mindestens 100 µm auf.

Zur Herstellung einer Wärmedämmschicht nach dem erfindungsgemässen Verfahren eignet sich ein oxidkeramisches Material oder ein Material, das oxidkeramische Komponenten enthält, wobei das oxidkeramische Material insbesondere ein mit Yttrium, Cer oder anderen Seltenerden vollständig oder teilweise stabilisiertes Zirkoniumoxid ist. Der als Stabilisator verwendete Stoff wird in Form eines Oxids der Seltenerden, beispielsweise Yttrium Y, Cer oder Scandium, dem Zirkoniumoxid zulegiert, wobei für das Beispiel von Y das Oxid einen Anteil von 5 bis 20 Gew-% bildet.

Damit der Pulverstrahl durch das defokussierende Plasma in eine Wolke aus Dampf und Partikeln umgeformt wird, aus der sich eine Schicht mit der angestrebten Mikrostruktur ergibt, muss das pulverförmige Ausgangsmaterial sehr feinkörnig sein. Die Grössenverteilung der Pulverpartikel wird mittels einer Laserstreumethode bestimmt. Für diese Grössenverteilung muss gelten, dass sie zu einem wesentlichen Teil im Bereich zwischen 1 und 50 µm, vorzugsweise zwischen 3 und 25 µm liegt. Zur Herstellung der Pulverpartikel können verschiedene Verfahren angewendet werden: beispielsweise Sprühtrocknen oder eine Kombination von Aufschmelzen und anschliessendem Brechen und/oder Mahlen der erstarrten Schmelze.

Bei der in Fig. 1 dargestellten Schicht, die eine gut ausgebildete kolumnare Mikrostruktur zeigt, sind für die Prozessparameter folgende Werte verwendet worden: Prozessdruck = 150 Pa; Prozessgas: Ar, 35 SLPM, und He, 60 SLPM; Pulverförderung: Förderrate = 20 g/min; Spritzabstand = 900 mm.

Nach einer Erhöhung der Förderrate auf 40 - 50 g/min, und ohne dass die anderen Parameter verändert werden, erhält man die in Fig. 2 abgebildete Schicht 1'. Die Mikrostruktur ist ansatzweise immer noch kolumnar ausgebildet; allerdings ist sie zur Verwendung als Wärmedämmschicht mit höchster Beständigkeit gegenüber thermischer Wechselbeanspruchung nicht mehr geeignet.

Nach einer weiteren Erhöhung der Förderrate auf Werte grösser als 60 g/min - siehe Schicht 1" in Fig. 3 - ist die kolumnare Mikrostruktur vollständig verschwunden. Auch eine Erhöhung des Prozessdrucks bzw. des Gasflusses führt zu einem Verschwinden der kolumnare Mikrostruktur. Interessanterweise entsteht eine profilierte Oberfläche mit stark ausgeprägten Erhebungen, wobei sich diese über Erhebungen des Substrats 2 gebildet haben. Auch bei den Schichten 1, 1' der Figuren 1 und 2 erkennt man, dass ein ähnlicher Zusammenhang zwischen der anisotropen Mikrostruktur und dem Oberflächenprofil des Substrats 2 besteht: Die länglichen Korpuskeln 10 gehen bevorzugt von Erhebungen des Substrats 2 aus.

Das in Fig. 4 schematisch dargestellte wärmedämmende Schichtsystem ist mittels LPPS-Dünnfilm-Prozessen auf einem Grundkörper 3 aufgebracht. Dieses Schichtsystem setzt sich zusammen aus einer Sperrschicht 3a, einer Heissgaskorrosionsschutzschicht 4, einer erfindungsgemäss aufgebrachten Wärmedämmschicht 1 auf keramischer Basis und einer Deckschicht 5, die als eine Glättungsschicht die Erosionsfestigkeit verbessert. Zwischen der Heissgaskorrosionsschutzschicht 4 und der Wärmedämmschicht 1 kann - nicht dargestellt - zusätzlich eine Schutzschicht auf oxidischer Basis vorgesehen sein.

Die aus der Sperrschicht 3a und der Heissgaskorrosionsschutzschicht 4 bestehende Grundschicht hat eine Schichtdicke, deren Wert zwischen 10 und 300 µm, vorzugsweise zwischen 25 und 150 µm ist. Für die Sperrschicht 3a wird beispielsweise eine NiAl- oder NiCr-Legierung auf den Grundkörper 3 abgeschieden, der aus einer Ni- oder Co-Basislegierung bestehen kann. Die Heissgaskorrosionsschutzschicht 4 besteht insbesondere zumindest teilsweise aus einem Metallaluminid, einer MeCrAlY-Legierung, wobei Me eines der Metalle Fe, Co oder Ni bedeutet oder aus einem oxidkeramischen Material. Sie weist vorzugsweise eine entweder dichte, kolumnare oder gleichgerichtete Struktur auf. Die Grundschicht 3a, 4 bildet das Substrat der Wärmedämmschicht 1, die erfindungsgemäss hergestellt ist und somit eine kolumnare Mikrostruktur aufweist. Die Glättungsschicht 5, deren Schichtdicke einen Wert zwischen 1 und 50 µm, vorzugsweise zwischen 10 und 30 µm aufweist, besteht insbesondere zumindest teilweise aus dem gleichen oder einem ähnlichen Material wie die Wärmedämmschicht. Die Teilschichten des Schichtsystem werden vorzugsweise alle durch LPPS-Dünnfilm-Prozesse in einem einzigen Arbeitszyklus ohne Unterbruch aufgebracht. Nach dem Aufbringen kann das Schichtsystem als Ganzes wärmebehandelt werden.

Beim erfindungsgemässen Verfahren kann auch eine zusätzliche Wärmequelle verwendet werden, um das Auftragen des Beschichtungsmaterials innerhalb eines vorgegebenen Temperaturbereichs durchzuführen. Die Temperatur wird im Bereich zwischen 300 und 900°C vorgegeben, vorzugsweise im Temperaturbereich 450 - 750°C. Als zusätzliche Wärmequelle lässt sich beispielsweise eine Infrarotlampe oder ein Plasmastrahl verwenden. Dabei wird eine Wärmezufuhr der Wärmequelle und die Temperatur im zu beschichtenden Substrat unabhängig von den bereits genannten Prozessparametem gesteuert oder geregelt. Die Temperaturkontrolle wird mit gängigen Messverfahren durchgeführt (unter Verwendung von IR-Sensoren, Thermofühler etc.).

Das erfindungsgemässe Verfahren lässt sich dazu anwenden, Bauteile, die hohen Prozesstemperaturen ausgesetzt werden, mit einem wärmedämmenden Schichtsystem zu beschichten. Solche Bauteile sind beispielsweise Komponenten einer stationären Gasturbine oder eines Flugzeugtriebwerks: nämlich Turbinenschaufeln, insbesondere Leit- oder Laufschaufeln, oder auch heissgasbeaufschlagbare Komponenten, z. B. ein Hitzeschild.

Mit dem erfindungsgemässen Verfahren kann auch eine poröse Trägerstruktur für katalytisch aktive Stoffe hergestellt werden, die in einem heterogenen Katalysator verwendbar ist.

## Patentansprüche

1. Verfahren zur Herstellung eines wärmedämmenden Schichtsystems (3a, 4, 1, 5) auf einem metallischen Substrat (2) oder Grundkörper (3), wobei das Schichtsystem mindestens eine anisotrop strukturierte, längliche Korpuskeln (10) aufweisende Wärmedämmschicht (1) umfaßt,
**dadurch gekennzeichnet, daß**
die Wärmedämmschicht (1) durch ein LPPS-Dünnfilm-Verfahren aufgebracht wird, bei dem ein Beschichtungsmaterial in Form eines Pulverstrahls auf eine Oberfläche eines metallischen Substrats (2) aufgespritzt wird, wobei das Beschichtungsmaterial oxidkeramische Komponenten enthält und bei einem niedrigen Prozeßdruck, der zwischen 50 und 2000 Pa, insbesondere zwischen 100 und 800 Pa beträgt, mittels einem Fördergas in ein den Pulverstrahl defokussierendes Plasma injiziert und dort teilweise oder vollständig geschmolzen wird, und ein Plasma mit ausreichend hoher spezifischer Enthalpie erzeugt wird, wobei das Prozeßgas für die Erzeugung des Plasmas ein Gemisch von Inertgasen mit einem Gesamtgasfluß im Bereich von 30 bis 150 SPLM ist, und die spezifische Enthalpie des Plasmas durch Abgabe einer effektiven Leistung erzeugt wird, die im Bereich von 40 bis 80 kW liegt und empirisch zu ermitteln ist, so dass ein substanzieller, mindestens 5 Gew-% betragender Anteil des Beschichtungsmaterials in die Dampfphase übergeht und auf dem Substrat (2) eine anisotrop strukturierte Wärmedämmschicht (1) entsteht, wobei in dieser Wärmedämmschicht (1) längliche Korpuskeln (10), die eine anisotrope Mikrostruktur bilden, weitgehend senkrecht zur Substratoberfläche stehend ausgerichtet sind und materialarme Übergangsbereiche (11, 12) die Korpuskeln gegeneinander begrenzen.

2. Verfahren nach Anspruch 1, **dadurch gekennzeichnet, daß** das für das Prozessgas zu verwendende Gemisch von Inertgasen aus Argon und Helium besteht, wobei das Volumenverhältnis von Ar zu He bevorzugt von 2 : 1 bis 1 : 4 beträgt.

3. Verfahren nach Anspruch 1 oder 2, **dadurch gekennzeichnet, daß** die Pulverförderrate des Beschichtungsmaterials zwischen 5 und 60 g/min, insbesondere zwischen 10 und 40 g/min beträgt.

4. Verfahren nach einem der Ansprüche 1 bis 3, **dadurch gekennzeichnet, daß** die Wärmedämmschicht (1) in einer Gasturbine zur Anwendung kommt und deren Schichtdicke Werte zwischen 20 und 1000 µm, vorzugsweise Werte von mindestens 100 µm aufweist, und dass bei der Herstellung die Schicht aus einer Mehrzahl von Lagen aufgebaut wird.

5. Verfahren nach einem der Ansprüche 1 bis 4, **dadurch gekennzeichnet, dass** das Substrat (2) während des Materialauftrags mit Dreh- oder Schwenkbewegungen relativ zu einer Wolke des defokussierten Pulverstrahls bewegt wird.

6. Verfahren nach einem der Ansprüche 1 bis 5, **dadurch gekennzeichnet. daß** eine oxidkeramische Komponente des Beschichtungsmaterials ein mit Yttrium, Cer oder anderen Seltenerden vollständig oder teilweise stabilisiertes Zirkoniumoxid ist, und der als Stabilisator verwendete Stoff in Form eines Oxids der genannten Seltenerden dem Zirkoniumoxid zulegiert ist.

7. Verfahren nach Anspruch 6, **dadurch gekennzeichnet, dass** für das pulverförmige Beschichtungsmaterial die Grössenverteilung der Pulverpartikel mittels einer Laserstreumethode bestimmt wird und dass diese Grössenverteilung zu einem wesentlichen Teil im Bereich zwischen 1 und 50 µm, bevorzugt zwischen 3 und 25 µm liegt, wobei zur Herstellung der Pulverpartikel als Verfahren insbesondere Sprühtrocknen oder eine Kombination von Aufschmelzen und anschliessendem Brechen und/oder Mahlen angewendet werden.

8. Verfahren nach einem der Ansprüche 1 bis 7, **dadurch gekennzeichnet, daß** eine zusätzliche Wärmequelle verwendet wird, um das Auftragen des Beschichtungsmaterials innerhalb eines vorgegebenen Temperaturbereichs durchführen zu können, wobei ein Wärmeeintrag der Wärmequelle und die Temperatur im zu beschichtenden Substrat unabhängig von den bereits genannten Prozeßparametern gesteuert oder geregelt wird.

9. Verfahrens nach Anspruch 8, **dadurch gekennzeichnet, daß** das wärmedämmende Schichtsystem (3a, 4, 1, 5) außer der Wärmedämmschicht (1) eine Grundschicht (3a, 4) zwischen einem Grundkörper (3) und der Wärmedämmschicht (1) und/oder eine Deckschicht (5) auf der Wärmedämmschicht (1) umfasst, wobei
a) die Grundschicht eine Heissgaskorrosionsschutzschicht (4) umfasst, deren Schichtdicke einen Wert zwischen 10 und 300 µm, bevorzugt zwischen 25 und 150 µm aufweist, und die zumindest teilweise aus entweder einem Metallaluminid, einer MeCrAlY-Legierung, wobei Me eines der Metalle Fe, Co oder Ni bedeutet, oder einem oxidkeramischen Material besteht, und eine entweder dichte, kolumnare oder gleichgerichtete Struktur aufweist,
b) die Deckschicht eine Glättungsschicht ist, deren Schichtdicke einen Wert zwischen 1 und 50 µm, bevorzugt zwischen 10 und 30 µm aufweist, und die zumindest teilweise aus dem gleichen oder einem ähnlichen Material wie die Wärmedämmschicht besteht, und
c) die Teilschichten des Schichtsystems alle durch LPPS-Dünnfilm-Prozesse in einem einzigen Arbeitszyklus aufgebracht werden.

10. Verfahren nach einem der Ansprüche 1 bis 9, **dadurch gekennzeichnet, daß** das Substrat (2) oder der Grundkörper (3) aus einer Ni- oder Co-Basislegierung besteht.

11. Verfahren nach einem der Ansprüche 1 bis 10, **dadurch gekennzeichnet, daß** das wärmedämmende Schichtsystem nach Durchführung der Beschichtungsprozesses einer Wärmebehandlung unterworfen wird.

12. Verfahren nach einem der Ansprüche 1 bis 11, **dadurch gekennzeichnet, daß** das Substrat eine Turbinenschaufel einer stationären Gasturbine oder eines Flugtriebwerks ist, insbesondere eine Leit- oder Laufschaufel, oder eine heissgasbeaufschlagbare Komponente, beispielsweise ein Hitzeschild.

## Claims

1. A method for the manufacture of a thermally insulating layer system (3a, 4, 1, 5) on a metallic substrate (2) or base body (3), wherein the layer system includes at least one anisotropically structured thermally insulating layer (1) having elongate corpuscles (10),
**characterized in that**
the thermally insulating layer (1) is applied by an LPPS thin film process in which a coating material in the form of a powder stream is sprayed onto a surface of a metallic substrate (2), with the coating material containing oxide ceramic components, being injected at a low process pressure which amounts to between 50 and 2000 Pa, and in particular to between 100 and 800 Pa, by means of a feed gas into a plasma which defocuses the powder stream and being partly or completely melted there, with a plasma with an adequately high specific enthalpy being generated, with the process gas for the generation of the plasma being a mixture of inert gases with a total gas flow in the range from 30 to 150 SPLM and with the specific enthalpy of the plasma being generated by the output of an effective power which lies in the range from 40 to 80 kW and can be empirically determined so that a substantial proportion of the coating material amounting to at least 5 % by weight passes into the vapor phase and an anisotropically structured thermally insulating layer (1) arises on the substrate (2), wherein elongate corpuscles (10) in this thermally insulating layer (1), which form an anisotropic microstructure are aligned substantially perpendicular to the substrate surface and transition regions with little material (11, 12) delimits the corpuscles relative to one another.

2. A method in accordance with claim 1, **characterized in that** the mixture of inert gases to be used for the process gas consists of argon and helium, with the volume ratio of argon to helium preferably amounting to 2 : 1 to 1 : 4.

3. A method in accordance with claim 1 or claim 2, **characterized in that** the powder supply rate of the coating material amounts to between 5 and 60 g/ min, in particular to between 10 and 40 g/ min.

4. A method in accordance with one of the claims 1 to 3, **characterized in that** the thermally insulating layer (1) is used in a gas turbine and its layer thickness has values between 20 and 1000 µm, or preferably values of at least 100 µm, and **in that** during manufacture the coating is built up of a plurality of layers.

5. A method in accordance with one of the claims 1 to 4, **characterized in that** the substrate (2) is moved during the material deposition with rotary movements or pivoting movements relative to a cloud of the defocused powder stream.

6. A method in accordance with any one of the claims 1 to 5, **characterized in that** an oxide ceramic component of the coating material is a zirconium oxide completely or partly stabilized with yttrium, cerium or other rare earths and **in that** the material used as a stabilizer is alloyed with the zirconium oxide in the form of an oxide of the named rare earths.

7. A method in accordance with claim 6, **characterized in that** the size distribution of the powder particles for the powder formed coating material is determined by means of a laser scattering method and **in that** this size distribution lies in a predominant part in the range between 1 and 50 µm, preferably between 3 and 25 µm, with spray-drying or a combination of melting and subsequent breaking and/or grinding being used as a method for the manufacture of the power particles.

8. A method in accordance with any one of the claims 1 to 7, **characterized in that** an additional heat source is used in order to carry out the deposition of the coating material within a predetermined temperature range, with a heat input of the heat source and the temperature in the substrate to be coated being controlled or regulated independently of the already named process parameters.

9. A method in accordance with claim 8, **characterized in that** the thermally insulating layer system (3a, 4, 1, 5) includes, apart from the thermally insulating layer (1), a base layer (3a, 4) between a base body (3) and the thermally insulating layer (1) and/or a cover layer (5) on the thermally insulating layer, wherein
a) the base layer includes a hot gas corrosion protection layer (4), the layer thickness of which has a value between 10 and 300 µm, preferably between 25 and 150 µm, and which consists at least partly of either a metal aluminide, of a MeCrAlY alloy, with Me signifying one of the metals Fe, Co or Ni, or of an oxide ceramic material and has an either dense columnar or uniformly directed structure,
b) the cover layer is a smoothing layer, the layer thickness of which has a value between 1 and 50 µm, preferably between 10 and 30 µm, and which consists at least partly of the same or a similar material to the thermally insulating layer, and
c) the part layers of the layer system are all applied by LPPS thin film processes in a single working cycle.

10. A method in accordance with any one of the claims 1 to 9, **characterized in that** the substrate (2) or the base body (3) consists of a nickel or cobalt based alloy.

11. A method in accordance with any one of the claims 1 to 10, **characterized in that** the thermally insulating layer system is subjected to a thermal treatment after carrying out the coating process.

12. A method in accordance with any one of the claims 1 to 11, **characterized in that** the substrate is a turbine blade of a stationary gas turbine or of an aircraft engine, in particular a guide vane or rotor blade or a component acted on by hot gas, for example a heat shield.

## Revendications

1. Procédé de fabrication d'un système à couches calorifuge (3a, 4, 1, 5) sur un substrat métallique (2) ou un corps de base (3), où le système à couches comprend au moins une couche calorifuge de structure anisotrope (1), présentant des corpuscules oblongs (10),
**caractérisé en ce que**
la couche calorifuge (1) est appliquée par un procédé de film mince LPPS, dans lequel un matériau de revêtement est projeté sous forme d'un jet de poudre sur une surface d'un substrat métallique (2), où le matériau de revêtement contient des composants de céramique oxydée et est injecté à une pression de traitement basse, qui se situe entre 50 et 2000 Pa, en particulier entre 100 et 800 Pa, au moyen d'un gaz convoyeur dans un plasma défocalisant le jet de poudre et y est amené à fondre partiellement ou complètement, et un plasma d'une enthalpie spécifique suffisamment élevée est produit, où le gaz de traitement pour la production du plasma est un mélange de gaz inertes avec un flux de gaz total dans la plage de 30 à 150 SPLM, et l'enthalpie spécifique du plasma est produite par l'émission d'une puissance effective qui se situe dans la plage de 40 à 80 kW et qui doit être déterminée de manière empirique de sorte qu'une part substantielle, représentant au moins 5% en poids du matériau de revêtement passe en phase vapeur, et sur le substrat (2), une couche calorifuge (1) de structure anisotrope est produite, où dans cette couche calorifuge (1), des corpuscules oblongs (10), qui forment une microstructure anisotrope, s'étendent sensiblement perpendiculairement à la surface du substrat et des zones de transition (11, 12) pauvres en matériau délimitent les corpuscules les uns contre les autres.

2. Procédé selon la revendication 1, **caractérisé en ce que** le mélange de gaz inertes à utiliser pour le gaz de processus est constitué d'argon et d'hélium, où le rapport volumique de Ar à He est de préférence de 2 : 1 à 1 : 4.

3. Procédé selon la revendication 1 ou 2, **caractérisé en ce que** le taux de convoyage de poudre du matériau de revêtement est entre 5 et 60 g/min, en particulier entre 10 et 40 g/min.

4. Procédé selon l'une des revendications 1 à 3, **caractérisé en ce que** la couche calorifuge (1) est utilisée dans une turbine gaz, et son épaisseur de couche a des valeurs entre 20 et 1000 µm, de préférence des valeurs d'au moins 100 µm, et **en ce que** lors de la fabrication, la couche est formée par une pluralité de couches.

5. Procédé selon l'une des revendications 1 à 4, **caractérisé en ce que** le substrat (2), pendant l'application du matériau, est déplacé selon des mouvements de rotation ou de pivotement relativement à un nuage du jet de poudre défocalisé.

6. Procédé selon l'une des revendications 1 à 5, **caractérisé en ce qu'**un composant de céramique oxydé du matériau de revêtement est un oxyde de zirconium stabilisé complètement ou partiellement avec du yttrium, cérium ou autres terres rares, et **en ce que** le matériau utilisé comme stabilisateur est ajouté sous forme d'un oxyde des terres rares précitées à l'oxyde de zirconium.

7. Procédé selon la revendication 6, **caractérisé en ce que** pour le matériau de revêtement pulvérulent, la répartition de grandeur des particules de poudre est déterminée par une méthode de diffusion laser, et **en ce que** cette répartition de grandeur se situe pour une partie essentielle dans la zone entre 1 et 50 µm, de préférence entre 3 et 25 µm, où pour la fabrication des particules de poudre, comme procédé, sont utilisés en particulier le séchage par pulvérisation ou une combinaison de fusion et de rupture et/ou broyage suivants.

8. Procédé selon l'une des revendications 1 à 7, **caractérisé en ce qu'**une source de chaleur additionnelle est utilisée pour pouvoir exécuter l'application du matériau de revêtement à l'intérieur d'une plage de température prédéfinie, où une entrée de chaleur de la source de chaleur et la température dans le substrat à revêtir est commandée ou réglée indépendamment des paramètres de processus déjà indiqués.

9. Procédé selon la revendication 8, **caractérisé en ce que** le système à couches calorifuge (3a, 4, 1, 5), à part la couche calorifuge (1), comprend une couche de base (3a, 4) entre un corps de base (3) et la couche calorifuge (1) et/ou une couche de recouvrement (5) sur la couche calorifuge (1), où
a) la couche de base comprend une couche de protection (4) contre la corrosion par des gaz chauds, dont l'épaisseur de couche présente une valeur entre 10 et 300 µm, de préférence entre 25 et 150 µm, et qui est constituée au moins partiellement soit d'une aluminure métallique, d'un alliage MeCrAIY, où Me signifie un des métaux Fe, Co ou Ni, soit d'un matériau de céramique oxydée, et présente une structure soit dense, colonnaire ou dirigée dans le même sens,
b) la couche de recouvrement est une couche de lissage dont l'épaisseur de couche présente une valeur entre 1 et 50 µm, de préférence entre 10 et 30 µm et qui est constituée au moins partiellement du même matériau ou d'un matériau similaire que la couche calorifuge, et
c) les couches partielles du système à couches sont toutes appliquées par des processus de film mince LPPS lors d'un seul cycle de travail.

10. Procédé selon l'une des revendications 1 à 9, **caractérisé en ce que** le substrat (2) ou le corps de base (3) est constitué d'un alliage de base Ni ou Co.

11. Procédé selon l'une des revendications 1 à 10, **caractérisé en ce que** le système à couches calorifuge, après l'exécution du processus de revêtement, est soumis à un traitement thermique.

12. Procédé selon l'une des revendications 1 à 11, **caractérisé en ce que** le substrat est une aube de turbine d'une turbine à gaz stationnaire ou d'un mécanisme de propulsion d'avion, en particulier une aube directrice ou mobile, ou bien un composant pouvant être chargé en gaz chauds, par exemple un bouclier thermique.
